# EUROPEAN PATENT SPECIFICATION

(11) **EP 4 697 906 B1**
(45) Date of publication and mention of the grant of the patent: **14.10.2026**
(21) Application number: 25171437.4
(22) Date of filing: 17.04.2025
(51) Int. Cl.: H10K 30/40, H10K 39/15

(54) **TANDEM CELL, MANUFACTURING METHOD THEREOF, AND PHOTOVOLTAIC MODULE**
TANDEMZELLE, HERSTELLUNGSVERFAHREN DAFÜR UND FOTOVOLTAISCHES MODUL
CELLULE TANDEM, SON PROCÉDÉ DE FABRICATION ET MODULE PHOTOVOLTAÏQUE

(30) Priority: 14.08.2024 CN 202411111188
(43) Date of publication of application: 18.02.2026
(60) Divisional application: 26198476.9 / 4 815 691
(73) Proprietor: Jinko Solar (Shangrao) Co., Ltd., Shangrao, Jiangxi 334100 (CN); Jinko Solar (Haining) Co., Ltd., Haining City, Zhejiang (CN)
(72) Inventor: WANG, Jungan, Shangrao, 334100 (CN); XU, Menglei, Shangrao, 334100 (CN); YANG, Jie, Shangrao, 334100 (CN); ZHANG, Xinyu, Shangrao, 334100 (CN)
(74) Representative: Haseltine Lake Kempner LLP

(56) References cited:
- CN-A- 118 019 365
- US-A1- 2018 019 358
- US-A1- 2024 121 971
- US-A1- 2024 188 311

## Description

### TECHNICAL FIELD

The present application relates to the technical field of photovoltaics, and in particular, to a tandem cell, a manufacturing method thereof, and a photovoltaic module.

### BACKGROUND

For every 1% increase in a photoelectric conversion efficiency of a photovoltaic power generation device, a corresponding kilowatt-hour power cost is reduced by 5% to 7%. Currently, in a main stream photovoltaic power generation device, a crystalline silicon solar cell is adopted for photoelectric conversion, but difficulty of a continuous improvement of the photoelectric conversion efficiency of the crystalline silicon solar cell is increased.

A crystalline silicon/perovskite tandem cell has a theoretical efficiency exceeding 44% and an experimental research and development efficiency exceeding 31%, realizes a remarkable increase of the photoelectric conversion efficiency on the premise of a little cost increase, and is one of choices for continuously improving the photoelectric conversion efficiency of the photovoltaic cell in the future.

However, the tandem cell of a perovskite solar cell and the crystalline silicon solar cell is still in an early development stage, and has many disadvantages.

US 2024/121971 A1 describes solar cell modules and methods of fabrication.

US 2024/188311 A1 describes a solar cell including s a first photoelectric conversion portion, a second photoelectric conversion portion, a side insulating layer, a first electrode, and a second electrode.

US 2018/019358 A1 describes a tandem solar cell, a tandem solar cell module comprising the tandem solar cell, and a method for manufacturing the same.

CN 118 019 365 A describes a perovskite stacked module crystalline silicon triple-stacked solar cell and a preparation method thereof.

### SUMMARY

Accordingly, it is necessary to provide a tandem cell, a manufacturing method thereof, and a photovoltaic module.

In a first aspect, the present application provides a tandem cell, including:
a bottom cell, the bottom cell including a plurality of crystalline silicon solar cells, and a light receiving surface of each crystalline silicon solar cell being provided with a first metal electrode; and
a top cell, the top cell including a plurality of perovskite solar cells, the plurality of perovskite solar cells being stacked above the light receiving surfaces of the crystalline silicon solar cells, a side of the perovskite solar cell facing the light receiving surface of the crystalline silicon solar cell being provided with a metal grid line, and the metal grid line of the perovskite solar cells being in connection with the first metal electrode of the crystalline silicon solar cell by metal bonding.

In some embodiments, the plurality of crystalline silicon solar cells of the bottom cell are sequentially arranged along a first direction, and a backlight surface of the crystalline silicon solar cells away from the perovskite solar cells is provided with a second metal electrode;
the plurality of perovskite solar cells of the top cell are sequentially arranged along the first direction, a side of the top cell away from the bottom cell is provided with a transparent substrate, each perovskite solar cell includes a first transparent electrode, a first transmission layer, a perovskite layer, a second transmission layer, and a second transparent electrode that are sequentially stacked from the transparent substrate to the bottom cell, the metal grid line is arranged on a side of the second transparent electrode adj acent to the bottom cell, the perovskite solar cell further includes a side electrode, and the side electrode is provided on a side of the first transparent electrode facing the bottom cell;
the second metal electrode of the crystalline silicon solar cell is connected to the side electrode of the perovskite solar cell, so that the crystalline silicon solar cell andthe perovskite solar cell are connected in series or in parallel.

In some embodiments, the plurality of perovskite solar cells of the top cell are connected in parallel with each other, and the plurality of perovskite solar cells of the top cell and the plurality of crystalline silicon solar cells of the bottom cell are connected in parallel with each other;

In some embodiments, the plurality of perovskite solar cells of the top cell are connected into a plurality of groups connected in series, the perovskite solar cells of one group are connected in parallel with each other, and the plurality of groups of perovskite solar cells are connected to the plurality of crystalline silicon solar cells of the bottom cell in series.

In some embodiments, the top cell further includes a horizontal electrode, the horizontal electrode is arranged on the transparent substrate on one sides of the plurality of perovskite solar cells along a second direction perpendicular to the first direction, and one ends of the plurality of side electrodes are connected to the horizontal electrode;
the bottom cell further includes a busbar, the busbar is provided on a side of the horizontal electrode along the second direction, the busbar extends along the first direction, and one ends of the second metal electrodes of the plural crystalline silicon solar cells away from the horizontal electrode are connected to the busbar.

In some embodiments, the top cell includes:
a plurality of first horizontal electrodes, the first horizontal electrodes being provided on the transparent substrate on one side of the perovskite solar cell along the second direction, and the first horizontal electrodes being arranged at intervals along the first direction; and
a plurality of second horizontal electrodes, the second horizontal electrodes being provided on the transparent substrate on the other side of the perovskite solar cell along the second direction, and the second horizontal electrodes being arranged at intervals along the first direction;
the side electrodes of the perovskite solar cells in the same group are connected to the first horizontal electrode or the second horizontal electrode, and the plurality of groups of perovskite solar cells arranged along the first direction are alternately connected to the first horizontal electrode and the second horizontal electrode; and
one group of perovskite solar cells are stacked above each crystalline silicon solar cell, and along the first direction, the second metal electrode of each crystalline silicon solar cell is sequentially connected to the first horizontal electrodes or the second horizontal electrodes of the adjacent group of perovskite solar cells.

In a second aspect, the present application provides a method of manufacturing a tandem cell, including:
providing a transparent substrate;
forming a top cell on the transparent substrate, the top cell including a plurality of perovskite solar cells, and a top surface of each perovskite solar cell being provided with a metal grid line;
providing a bottom cell, the bottom cell including a plurality of crystalline silicon solar cells, and a light receiving surface of each crystalline silicon solar cell being provided with a first metal electrode; and
stacking the top cell and the bottom cell together, the top surface of the perovskite solar cell facing the light receiving surface of the crystalline silicon solar cell, and the metal grid line of the perovskite solar cell being in connection with the first metal electrode of the crystalline silicon solar cell by metal bonding.

In some embodiments, forming the top cell on the transparent substrate, the top cell including the plurality of perovskite solar cells includes:
forming a plurality of first transparent electrodes arranged at intervals along a first direction on the transparent substrate;
forming a first transmission layer on the first transparent electrode, the first transmission layer covering part of a top surface of the first transparent electrode and part of a top surface of the first transparent electrode adjacent thereto;
forming a perovskite layer, a second transmission layer, and a second transparent electrode that are sequentially stacked on the first transmission layer, and forming a metal electrode on the second transparent electrode; and
forming a side electrode on the top surface of each first transparent electrode not covered by the first transmission layer to form the plurality of perovskite solar cells;
wherein a second metal electrode is provided on a backlight surface of the crystalline silicon solar cell away from the perovskite solar cell, and after the top cell and the bottom cell are stacked together, the second metal electrode of the crystalline silicon solar cell is connected to the side electrode of the perovskite solar cell, so that the crystalline silicon solar cell and the perovskite solar cell are connected in series or in parallel.

In some embodiments, a horizontal electrode is formed on the transparent substrate while the side electrode is formed, the horizontal electrode is provided on one sides of the plurality of perovskite solar cells along a second direction perpendicular to the first direction, and the plurality of side electrodes are connected to the horizontal electrode;
after stacking the top cell and the bottom cell together, the manufacturing method further includes: connecting ends of the second metal electrodes of the plurality of crystalline silicon solar cells away from the horizontal electrode along the second direction to a busbar, the busbar extending parallel to the horizontal electrode along the first direction, so that the plurality of perovskite solar cells of the top cell are connected in parallel with each other, and the plurality of perovskite solar cells of the top cell and the plurality of crystalline silicon solar cells of the bottom cell are connected in parallel with each other.

In some embodiments, a plurality of first horizontal electrodes and a plurality of second horizontal electrodes are formed on the transparent substrate while the side electrode is formed, the first horizontal electrodes are provided on one side of the perovskite solar cell along the second direction, the first horizontal electrodes are arranged at intervals along the first direction, the second horizontal electrodes are arranged on the other side of the perovskite solar cell along the second direction, and the second horizontal electrodes are arranged intervals along the first direction;
the plurality of perovskite solar cells are connected into a plurality of groups through the first horizontal electrodes and the second horizontal electrodes, the side electrodes of the perovskite solar cells in the same group are connected to the first horizontal electrodes or the second horizontal electrodes, and the plurality of groups of perovskite solar cells arranged along the first direction are alternately connected to the first horizontal electrodes and the second horizontal electrodes;
the top cell and the bottom cell are stacked together, one group of perovskite solar cells are stacked above each crystalline silicon solar cell, and the second metal electrode of each crystalline silicon solar cell is connected to the first horizontal electrodes or the second horizontal electrodes of the adjacent group of perovskite solar cells along the first direction, so that the plurality of groups of perovskite solar cells of the top cell and the plurality of crystalline silicon solar cells of the bottom cell are connected in series.

In a third aspect, there is provided a photovoltaic module, including the tandem cell of the first aspect, or a tandem cell manufactured by the manufacturing method of a tandem cell of the second aspect.

According to the tandem cell, the manufacturing method thereof, and the photovoltaic module of the present application, the top cell is stacked on the bottom cell, the metal grid line of the perovskite solar cell of the top cell is in ohmic contact with the first metal electrode of the crystalline silicon solar cell of the bottom cell, a contact resistance of the perovskite solar cell and the crystalline silicon solar cell is small, and conductivity is improved, which facilitates an increase of density of a current transmitted between the perovskite solar cell and the crystalline silicon solar cell, and facilitates an improvement of a photoelectric conversion efficiency of the tandem cell.

### BRIEF DESCRIPTION OF THE DRAWINGS

In order to illustrate the technical solutions in the embodiments of the present application or the prior art more clearly, the drawings required for describing the embodiments or the prior art will be described briefly. Apparently, the following described drawings are merely for some embodiments of the present application, and other drawings can be derived from the drawings by those of ordinary skill in the art without any creative effort.
FIG. 1 is a schematic structural view of a tandem cell according to one or more embodiments;
FIG. 2 is a top view of a backlight surface of a top cell of the tandem cell according to one or more embodiments;
FIG. 3 is a top view of the backlight surface of the top cell of the tandem cell according to one or more embodiments;
FIG. 4 is a top view from a backlight surface of a bottom cell of the tandem cell according to one or more embodiments;
FIG. 5 is a top view from the backlight surface of the bottom cell of the tandem cell according to one or more embodiments;
FIG. 6 is a process flowchart of a method of manufacturing a tandem cell according to one or more embodiments;
FIG. 7 is a schematic structural view after a first transparent electrode is formed on a transparent substrate in one or more embodiments;
FIG. 8 is a schematic structural view after a first transmission layer, a perovskite layer, a second transmission layer, and a second transparent electrode are formed in one or more embodiments; and
FIG. 9 is a schematic structural view of a top electrode formed in one or more embodiments.

### Reference signs

100: bottom cell; 10: crystalline silicon solar cell; 11: first metal electrode; 12: second metal electrode; 13: crystalline silicon substrate; 14: first passivation layer; 15: first anti-reflective layer; 16: second passivation layer; 17: second anti-reflective layer; 200: top cell; 20: perovskite solar cell; 30: transparent substrate; 21: first transparent electrode; 22: first transmission layer; 23: perovskite layer; 24: second transmission layer; 25: second transparent electrode; 26: metal grid line; 261: primary grid; 262: finger; 27: side electrode; 28: horizontal electrode; 128: first horizontal electrode; 228: second horizontal electrode; 29: edge clearing region; 41: first groove; 42: second groove; 50: busbar; D1: first direction; D2: second direction.

### DETAILED DESCRIPTION

To facilitate an understanding of the present application, the present application is described more fully hereinafter with reference to the accompanying drawings. Preferred embodiments of the present application are shown in the drawings. However, the present application may be implemented in many different forms and is not limited to the embodiments set forth herein. Rather, these embodiments are provided to make the application of the present application more thorough and complete.

Unless defined otherwise, all technical and scientific terms used herein have the same meanings as would generally understood by those skilled in the technical field of the present application. The terms used herein in the specification of the present application are for the purpose of describing specific embodiments only, and are not intended to limit the present application.

As described in the background, a tandem cell of a perovskite solar cell and a crystalline silicon solar cell is still in an early development stage, and has many disadvantages. In a first related art, in the tandem cell of the perovskite solar cell and the crystalline silicon solar cell, the perovskite solar cell is deposited and manufactured on the crystalline silicon solar cell, and then, a plurality of tandem cells are connected in series. However, the perovskite solar cell manufactured in this way is poor in uniformity, so that the tandem cell is poor in performance and low in yield, and extra crystalline silicon substrate waste is caused. In a second related art, a conductive adhesive layer is arranged between the crystalline silicon solar cell and the perovskite solar cell, and the crystalline silicon solar cell and the perovskite solar cell are mechanically connected through the conductive adhesive layer. However, the additional conductive adhesive layer also increases light loss, which is not favorable for further improving a photoelectric conversion efficiency, and conductivity realized when the crystalline silicon solar cell and the perovskite solar cell are connected through the conductive adhesive layer lacks a guarantee. In related solutions, a connection mode of the stacked single tandem cells is not designed, and a feasible design for forming the single tandem cells into a large-sized tandem photovoltaic module suitable for a photovoltaic power generation device is lacked.

In view of this, the present application provides a tandem cell, a manufacturing method thereof, and a photovoltaic module. On the one hand, a perovskite solar cell of a top cell is stacked above a crystalline silicon solar cell of a bottom cell, a metal grid line of the perovskite solar cell is connected to a first metal electrode of the crystalline silicon solar cell, an on-resistance of the connection between the metal grid line and the first metal electrode is small, the top cell and the bottom cell have better conductivity, and no additional adhesive layer is provided between the top cell and the bottom cell, which avoids light loss caused by the adhesive layer, and facilitates a further improvement of a photoelectric conversion efficiency of the tandem cell. On the other hand, a manufacturing cost of the tandem cell is reduced by adopting the mode that the metal grid line of the perovskite solar cell is mechanically connected to the first metal electrode of the crystalline silicon solar cell in the present application. Meanwhile, the present application further provides various feasible connection designs after the perovskite solar cell and the crystalline silicon solar cell are laminated, and the perovskite solar cell of the top cell and the crystalline silicon solar cell of the bottom cell are connected to form a large-sized tandem cell, so that the tandem cell is suitable for photovoltaic conversion of a photovoltaic power generation device.

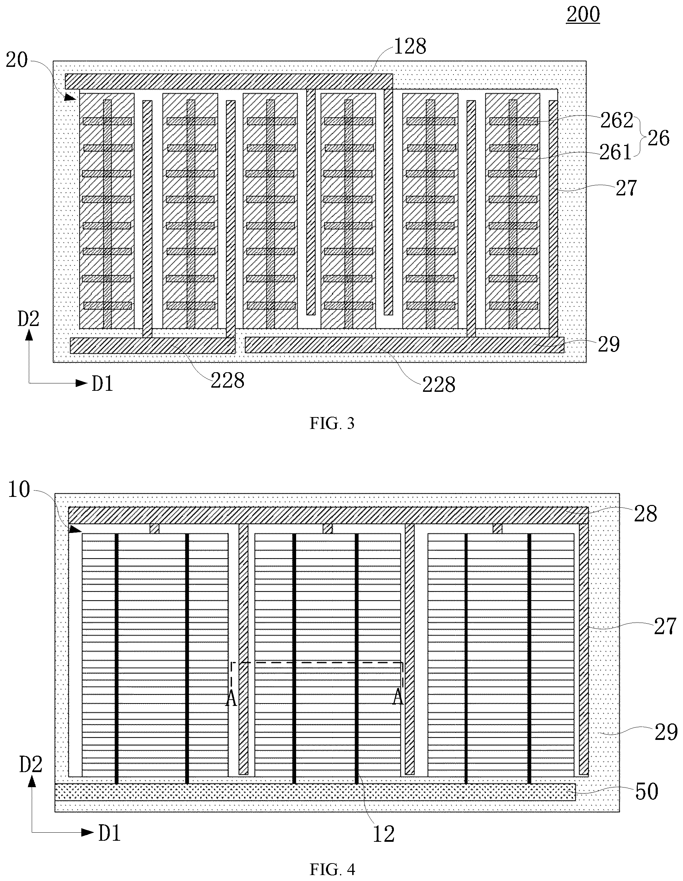

According to some embodiments, a tandem cell is provided. Referring to FIG. 1, FIG. 2, FIG. 3, FIG. 4, and FIG. 5, FIG. 1 is a sectional view of the tandem cell taken along line A-A in FIG. 4. The tandem cell includes a bottom cell 100 and a top cell 200. The bottom cell 100 includes a plurality of crystalline silicon solar cells 10. Light receiving surfaces of the crystalline silicon solar cells 10 are provided with first metal electrodes 11. The top cell 200 is stacked above the bottom cell 100. The top cell 200 includes a plurality of perovskite solar cells 20, and the perovskite solar cells 20 are stacked above the crystalline silicon solar cells 10. A side of each perovskite solar cell 20 facing the light receiving surface of the crystalline silicon solar cell 10 is provided with a metal grid line 26, and the metal grid line 26 of the perovskite solar cell 20 is in contact connection with the first metal electrode 11 of the crystalline silicon solar cell 10. The contact connection means an ohmic contact connection between the metal grid line 26 of the perovskite solar cell 20 and the first metal electrode 11 of the crystalline silicon solar cell 10.

The metal grid line 26 of the perovskite solar cell 20 and the first metal electrode 11 of the crystalline silicon solar cell 10 may be connected by mechanical crimping. The metal grid line 26 of the perovskite solar cell 20 and the first metal electrode 11 of the crystalline silicon solar cell 10 are connected by metal bonding. In a non-inventive example,a conductive silver paste may be applied between the metal grid line 26 of the perovskite solar cell 20 and the first metal electrode 11 of the crystalline silicon solar cell 10, and the metal grid line 26 of the perovskite solar cell 20 and the first metal electrode 11 of the crystalline silicon solar cell 10 are connected through the conductive silver paste.

In the above tandem cell, the top cell 200 is stacked above the bottom cell 100, the metal grid line 26 of the perovskite solar cell 20 of the top cell 200 is in ohmic contact with the first metal electrode 11 of the crystalline silicon solar cell 10 of the bottom cell 100, a contact resistance of the perovskite solar cell 20 and the crystalline silicon solar cell 10 is small, and conductivity is improved, which facilitates an increase of density of a current transmitted between the perovskite solar cell 20 and the crystalline silicon solar cell 10, and facilitates the improvement of the photoelectric conversion efficiency of the tandem cell.

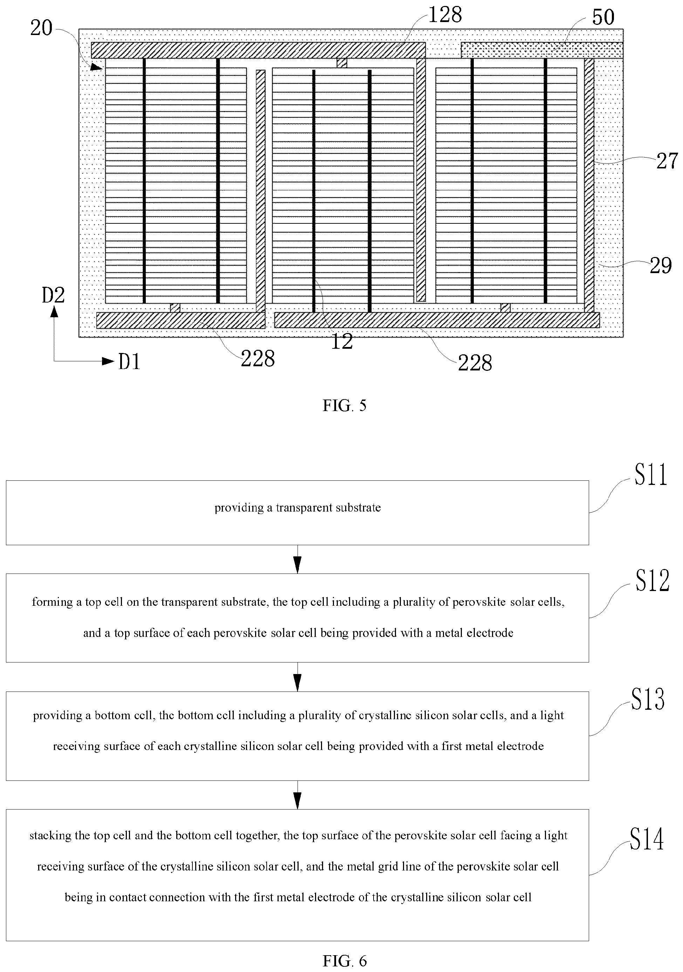

In some embodiments, referring to FIG. 4 and FIG. 5, the plurality of crystalline silicon solar cells 10 of the bottom cell 100 are sequentially arranged along a first direction D1, and backlight surfaces of the crystalline silicon solar cells 20 away from the perovskite solar cells 10 are provided with second metal electrodes 12.

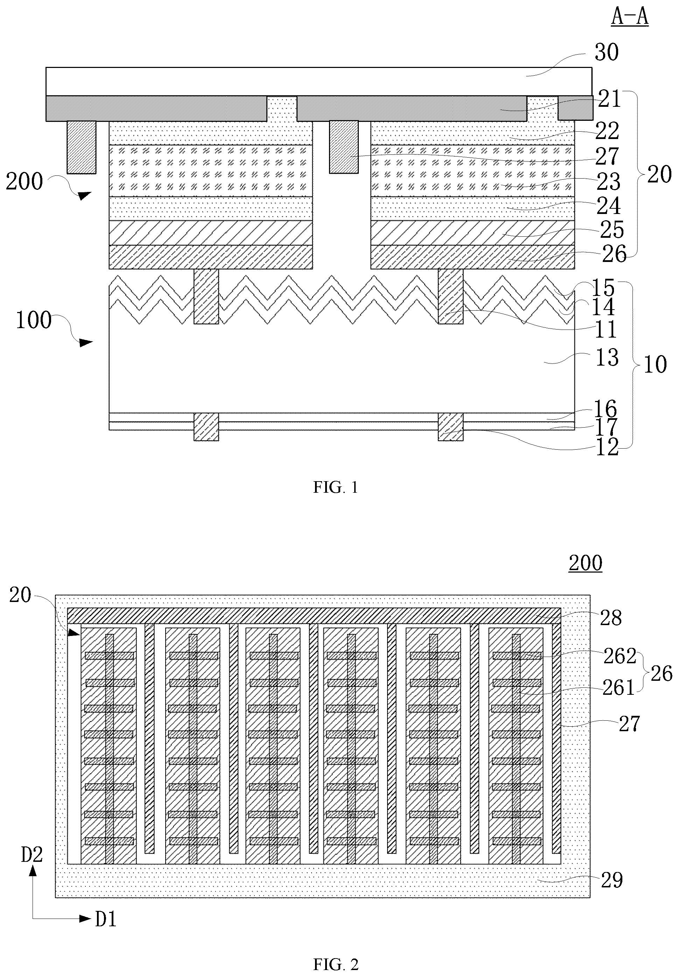

Referring to FIG. 1, FIG. 2, and FIG. 3, the plural perovskite solar cells 20 of the top cell 200 are sequentially arranged along the first direction D1. A side of the top cell 200 away from the bottom cell 100 is provided with a transparent substrate 30. Each perovskite solar cell 20 includes a first transparent electrode 21, a first transmission layer 22, a perovskite layer 23, a second transmission layer 24, and a second transparent electrode 25 that are sequentially stacked from the transparent substrate 30 to the bottom cell 100. The metal grid line 26 is provided on a side of the second transparent electrode 25 adjacent to the bottom cell 100. The perovskite solar cell 20 further includes a side electrode 27, and the side electrode 27 is provided on a side of the first transparent electrode 21 facing the bottom cell 100.

The second metal electrode 12 of the crystalline silicon solar cell 10 is connected to the side electrode 27 of the perovskite solar cell 20, so that the crystalline silicon solar cell 10 and/or the perovskite solar cell 20 are connected in series or in parallel.

The structure of the crystalline silicon solar cell 10 is not limited herein. In some embodiments, the crystalline silicon solar cell 10 may include a crystalline silicon substrate 13. The crystalline silicon substrate 13 has a light receiving surface and a backlight surface, and the light receiving surface of the crystalline silicon substrate 13 is a textured surface. The light receiving surface has a pn emitter junction (not shown in the drawings). A first passivation layer 14 and a first anti-reflective layer 15 are sequentially stacked on the light receiving surface, the first metal electrode 11 is arranged on the light receiving surface of the crystalline silicon substrate 13 and is in contact connection with the pn emitter junction, and the first metal electrode 11 protrudes from the first passivation layer 14 and the first anti-reflective layer 15. It should be understood that, the backlight surface of the crystalline silicon substrate 13 can also be used to absorb light. A second passivation layer 16 and a second anti-reflective layer 17 are sequentially stacked on the backlight surface of the crystalline silicon substrate 13. A second metal electrode 12 is arranged on the backlight surface, and the second metal electrode 12 is in contact connection with the backlight surface and protrudes from the second passivation layer 16 and the second anti-reflective layer 17.

Referring to FIG. 4 and FIG. 5, the plurality of crystalline silicon solar cells 10 of the bottom cell 100 are sequentially arranged along the first direction D1, the plurality of perovskite solar cells 20 of the top cell 200 are sequentially arranged along the first direction D1, and one or more perovskite solar cells 20 may be stacked above each crystalline silicon solar cell 10. It can be understood that a number of the perovskite solar cells 20 stacked above each crystalline silicon solar cell 10 may be flexibly adjusted according to a size of the crystalline silicon solar cell 10 and a size of the perovskite solar cell 20.

It should be understood that in order to ensure high uniformity of the perovskite solar cell 20, the size of the perovskite solar cell 20 is typically made smaller, and in order to match currents of the top cell 200 and the bottom cell 100, a plurality of perovskite solar cells 20 are typically stacked above one crystalline silicon solar cell 10. For example, 2, 3, 4, or more perovskite solar cells 20 are stacked above one crystalline silicon solar cell 10.

In some embodiments, by providing the side electrode 27 on the perovskite solar cell 20, using the side electrode 27 as a connecting wire of the tandem cell, and connecting the second metal electrode 12 of the crystalline silicon solar cell 10 to the side electrode 27 of the perovskite solar cell 20, by adjusting the connection mode, the crystalline silicon solar cells 10 can be connected in series or in parallel, the perovskite solar cells 20 can be connected in series or in parallel, and the crystalline silicon solar cells 10 and the perovskite solar cells 20 can be connected in series or in parallel, so as to connect the perovskite solar cells 20 of the top cell 200 and the crystalline silicon solar cells 10 of the bottom cell 100 to form the large-sized tandem cell which is suitable for photovoltaic conversion of the photovoltaic power generation device.

The side electrode 27 has good conductivity, and the side electrode 27 is used as the connecting wire of the tandem cell, which can reduce a connection resistance of the perovskite solar cell 20 and the crystalline silicon solar cell 10, facilitate an improvement of a conductive efficiency of the perovskite solar cell 20 and the crystalline silicon solar cell 10, and improve an electrical transmission efficiency of the tandem cell.

In some embodiments, referring to FIG. 1, FIG. 2, and FIG. 4, the plurality of perovskite solar cells 20 of the top cell 200 are connected in parallel with each other, and the plurality of perovskite solar cells 20 of the top cell 200 and the plurality of crystalline silicon solar cells 10 of the bottom cell 100 are connected in parallel with each other. Alternatively, the plurality of perovskite solar cells 20 of the top cell 200 are connected into a plurality of groups connected in series, the perovskite solar cells 20 of the same group are connected in parallel with each other, and the plurality of groups of perovskite solar cells 20 are connected to the plurality of crystalline silicon solar cells 10 of the bottom cell 100 in series. In this way, some embodiments provide a plurality of feasible connection designs after the perovskite solar cell 20 and the crystalline silicon solar cell 10 are stacked, and the perovskite solar cell 20 of the top cell 200 and the crystalline silicon solar cell 10 of the bottom cell 100 are connected to form the large-sized tandem cell, so that the tandem cell is suitable for photovoltaic conversion of the photovoltaic power generation device.

In some embodiments, the top cell 200 further includes a horizontal electrode 28, the horizontal electrode 28 is arranged on the transparent substrate 30 on one sides of the plurality of perovskite solar cells 20 along a second direction D2 perpendicular to the first direction D1, and ends of the plurality of side electrodes 27 are connected to the horizontal electrode 28.

The bottom cell 100 further includes a busbar 50, the busbar 50 is arranged on a side of the horizontal electrode 28 along the second direction D2. The busbar 50 extends along the first direction D1, and ends of the second metal electrodes 12 of the plural crystalline silicon solar cells 10 away from the horizontal electrode 28 are connected to the busbar 50.

The side electrode 27 of the perovskite solar cell 20 extends along the second direction D2, one end of the side electrode 27 is connected to the horizontal electrode 28 extending along the first direction D1. The second metal electrode 12 of the crystalline silicon solar cell 10 extends along the second direction D2, and the second metal electrode 12 is connected to the busbar 50 extending along the first direction D1.

In this way, the metal grid lines 26 of the perovskite solar cells 20 of the top cell 200 are connected to the first metal electrodes 11 of the plural crystalline silicon solar cells 10 of the bottom cell 100, the side electrodes 27 of the plural perovskite solar cells 20 of the top cell 200 are connected to the horizontal electrodes 28, and the second metal electrodes 12 of the plural crystalline silicon solar cells 10 of the bottom cell 100 are connected to the busbar 50, so that the plural perovskite solar cells 20 of the top cell 200 are connected in parallel with each other, the plural crystalline silicon solar cells 10 of the bottom cell 100 are connected in parallel with each other, the plural perovskite solar cells 20 of the top cell 200 and the plural crystalline silicon solar cells 10 of the bottom cell 100 are connected in parallel with each other, a feasible design is provided for connecting the perovskite solar cells 20 of the top cell 200 and the crystalline silicon solar cells 10 of the bottom cell 100 to form the large-sized tandem cell, and therefore, the tandem cell is suitable for photovoltaic conversion of the photovoltaic power generation device.

Further, referring to FIG. 1, FIG. 2, and FIG. 4, the first metal electrode 11 of the crystalline silicon solar cell 10 extends along the second direction D2, the metal grid line 26 of the perovskite solar cell 20 extends along the second direction D2, and the first metal electrode 11 of the crystalline silicon solar cell 10 is in ohmic connection with the metal grid line 26 of the perovskite solar cell 20. In some embodiments, a plurality of first metal electrodes 11 may be provided on the light receiving surface of the crystalline silicon solar cell 10, a plurality of perovskite solar cells 20 may be stacked on the light receiving surface of the crystalline silicon solar cell 10, and each first metal electrode 11 of the crystalline silicon solar cell 10 may be connected to the metal grid line 26 of each of the plural perovskite solar cells 20 correspondingly.

In some embodiments, the metal grid line 26 of the perovskite solar cell 20 include a primary grid 261 extending along the second direction D2 and a finger 262 connected to the primary grid 261. The finger 262 extends along the first direction D1, and the first metal electrode 11 of the crystalline silicon solar cell 10 is connected to the primary grid 261 of the perovskite solar cell 20.

In some embodiments, referring to FIG. 1, FIG. 3, and FIG. 5, the top cell 200 includes first horizontal electrodes 128 and second horizontal electrodes 228. The first horizontal electrodes 128 are provided on the transparent substrate 30 on one side of the perovskite solar cell 20 along the second direction D2, and the first horizontal electrodes 128 are arranged at intervals along the first direction D1. The second horizontal electrodes 228 are arranged on the transparent substrate 30 on the other side of the perovskite solar cell 20 along the second direction D2, and the second horizontal electrodes 228 are arranged at intervals along the first direction D1. The side electrodes 27 of the same group of perovskite solar cells 20 are connected to the first horizontal electrodes 128 or the second horizontal electrodes 228, and the plurality of groups of perovskite solar cells 20 arranged along the first direction D1 are alternately connected to the first horizontal electrodes 128 and the second horizontal electrodes 228.

One group of perovskite solar cells 20 are stacked above each crystalline silicon solar cell 10, and along the first direction D1, the second metal electrode 12 of each crystalline silicon solar cell 10 is sequentially connected to the first horizontal electrodes 128 or the second horizontal electrodes 228 of the adjacent group of perovskite solar cells 20.

**In** some embodiments, the plurality of perovskite solar cells 20 of the top cell 200 are connected into the plurality of groups arranged along the first direction D1, one group of perovskite solar cells 20 are stacked above each of the crystalline silicon solar cells 10, the side electrodes 27 of the same group of perovskite solar cells 20 are connected to the first horizontal electrode 128 or the second horizontal electrode 228. The plurality of groups of perovskite solar cells 20 arranged along the first direction D1 are alternately connected to the first horizontal electrodes 128 and the second horizontal electrodes 228. The second metal electrode 12 of the crystalline silicon solar cell 10 is connected to the first horizontal electrodes 128 or the second horizontal electrodes 228 of the adjacent group of perovskite solar cells 20, so that the perovskite solar cells 20 of the same group are connected in parallel, and an output current of the perovskite solar cell 20 stacked above the crystalline silicon solar cell 10 is increased to be fitted with the crystalline silicon solar cell 10. The plurality of groups of perovskite solar cells 20 arranged along the first direction D1 are sequentially connected in series, and the plurality of crystalline silicon solar cells 10 arranged along the first direction D1 are sequentially connected through the first horizontal electrode 128 and the second horizontal electrode 228 in series and then drawn out through the busbar 50.

**In** this way, the feasible design is provided for connecting the perovskite solar cell 20 of the top cell 200 to the crystalline silicon solar cell 10 of the bottom cell 100 to form the large-sized tandem cell, so that the tandem cell is suitable for photovoltaic conversion of the photovoltaic power generation device.

According to some embodiments, a method of manufacturing a tandem cell is provided, FIG. 6 is a process flowchart of the manufacturing method of a tandem cell according to some embodiments, the method of manufacturing the tandem cell according to some embodiments includes:
step S11: providing a transparent substrate;
step S12: forming a top cell on the transparent substrate, the top cell including a plurality of perovskite solar cells, and a top surface of each perovskite solar cell being provided with a metal grid line;
step S13: providing a bottom cell, the bottom cell including a plurality of crystalline silicon solar cells, and a light receiving surface of each crystalline silicon solar cell being provided with a first metal electrode; and
step S14: stacking the top cell and the bottom cell together, the top surface of the perovskite solar cell facing a light receiving surface of the crystalline silicon solar cell, and the metal grid line of the perovskite solar cell being in contact connection with the first metal electrode of the crystalline silicon solar cell.

In the method of manufacturing the tandem cell according to some embodiments, a perovskite solar cell of a top cell is stacked above a crystalline silicon solar cell of a bottom cell, a metal grid line of the perovskite solar cell is connected to a first metal electrode of the crystalline silicon solar cell, an on-resistance of the connection between the metal grid line and the first metal electrode is small, the top cell and the bottom cell have better conductivity, and no additional adhesive layer is provided between the top cell and the bottom cell, which avoids light loss caused by the adhesive layer, and facilitates a further improvement of a photoelectric conversion efficiency of the tandem cell. On the other hand, a manufacturing cost of the tandem cell is reduced by adopting the mode that the metal grid line of the perovskite solar cell is mechanically connected to the first metal electrode of the crystalline silicon solar cell in the present application.

Next, the manufacturing method of a tandem cell according to some embodiments is described in detail.

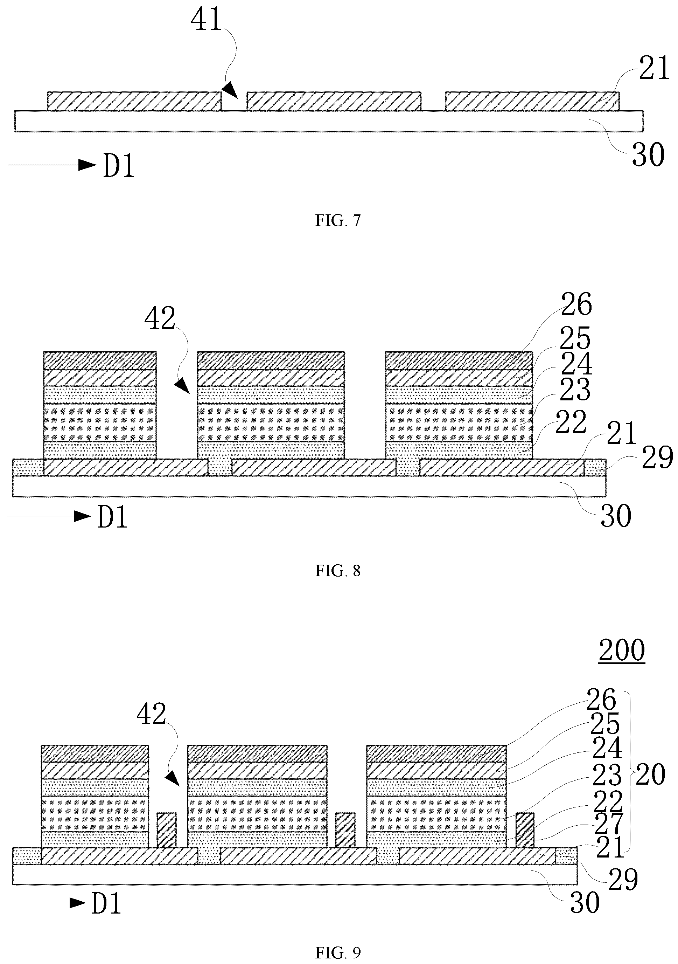

In the step S11, referring to FIG. 7, the transparent substrate 30 may be a glass substrate and/or a transparent polymer substrate. The transparent substrate 30 allows light to be transmitted from one side thereof to the other side. In this way, the light irradiated to the tandem cell from one side of the transparent substrate 30 may be absorbed by the perovskite solar cell 20 and the crystalline silicon solar cell 10 located on the other side of the transparent substrate 30.

In step S12 of forming the top cell on the transparent substrate, the top cell includes the plurality of perovskite solar cells, and the top surface of each perovskite solar cell is provided with the metal grid line, the following implementation may be adopted:
step S121: forming a plurality of first transparent electrodes arranged at intervals along a first direction on the transparent substrate.

Referring to FIG. 7, a first transparent conductive layer is deposited on the transparent substrate 30 by CVD or ALD, and then, a plurality of first grooves 41 extending along the second direction D2 and arranged at intervals along the first direction D1 are formed by laser etching of the first transparent conductive layer. The plurality of first grooves 41 divide the first transparent conductive layer into a plurality of independent first transparent electrodes 21, and the plurality of first transparent electrodes 21 are arranged at intervals along the first direction D1.

The first transparent electrode 21 may be made of one or more of indium tin oxide (ITO), indium zinc oxide (IZO), indium oxide doped tungsten oxide (IWO), and aluminum doped zinc oxide (AZO).

Step S122: forming a first transmission layer on the first transparent electrode, the first transmission layer covering part of a top surface of the first transparent electrode 21 and part of a top surface of the first transparent electrode adjacent thereto.

Step S123: forming a perovskite layer, a second transmission layer, and a second transparent electrode that are sequentially stacked on the first transmission layer, and forming a metal electrode on the second transparent electrode.

Referring to FIG. 7 and FIG. 8, after the first transparent electrode 21 is formed, the first transmission layer 22, the perovskite layer 23, the second transmission layer 24, and a second transparent conductive layer (not shown) may be sequentially deposited using CVD or ALD, and the first transmission layer 22, the perovskite layer 23, the second transmission layer 24, and the second transparent conductive layer cover the first transparent electrode 21 and fill the first groove 41.

Then, referring to FIG. 8 in conjunction with FIG. 2 and FIG. 3, the second transparent conductive layer, the second transmission layer 24, the perovskite layer 23, and the first transmission layer 22 are subjected to laser etching to form a plurality of second grooves 42 extending along the second direction D2 and arranged at intervals along the first direction D1, and each of the second grooves 42 correspondingly exposes part of a top surface of the first transparent electrode 21. The second transparent conductive layer is divided into a plurality of second transparent electrodes 25 by the second grooves 42.

The first transmission layer 22 may collect and transmit carriers generated in the perovskite layer 23, the first transmission layer 22 may be a hole transport layer or an electron transport layer, and the second transmission layer 24 may be an electron transport layer or a hole transport layer.

The first transmission layer 22 may be made of one or more of n-type single crystalline silicon, n-type polycrystalline silicon, n-type amorphous silicon, titanium dioxide, tin oxide, zinc oxide, zirconium dioxide, zinc gallium oxide, indium zinc oxide, fluorine doped tin oxide, indium tin oxide, barium stannate, titanium tin oxide, tin zinc oxide, fullerene, and fullerene derivatives. The second transmission layer 24 may be made of one or more of nickel oxide, copper oxide, cuprous iodide, and cuprous thiocyanate.

The second transparent electrode 25 may be made of one or more of indium tin oxide (ITO), indium zinc oxide (IZO), indium oxide doped tungsten oxide (IWO), and aluminum doped zinc oxide (AZO).

Next, a metal layer is deposited on the second transparent electrode 25, and a metal grid line 26 is formed by laser etching of the metal layer. The metal grid line 26 extends on the second transparent electrode 25 in the second direction D2.

The metal grid line 26 may be made of one or more of gold, silver, copper, iron, aluminum, cadmium, molybdenum, titanium, tin, tungsten, zinc, gallium, and germanium.

**In** some embodiments, the metal grid line 26 includes a primary grid 261 extending along the second direction D2 and a finger 262 connected to the primary grid 261, the finger 262 extending along the first direction D1.

After the plurality of perovskite solar cells 20 are formed, an edge clearing region 29 on a peripheral edge of the transparent substrate 30 is not covered with the perovskite solar cell 20.

Step S124: forming a side electrode on the top surface of each first transparent electrode not covered by the first transmission layer to form the plurality of perovskite solar cells.

Referring to FIG. 9, in conjunction with FIG. 2 and FIG. 3, a metal material may be deposited to fill the second groove 42, and then, the metal material is subjected to laser etching to form a side electrode 27 in the second groove 42. The side electrode 27 extends on the first transparent electrode 21 along the second direction D2, and at least one end of the side electrode 27 extends to the edge clearing region 29, so as to connect the side electrode 27 to the crystalline silicon solar cell 10 of the bottom cell 100.

A top surface of the side electrode 27 may be lower than a top surface of the second transparent electrode 25 or flush with the top surface of the second transparent electrode 25.

In this way, the plurality of perovskite solar cells 20 arranged in the first direction D1 are formed on the transparent substrate 30, and the bottom cell 100 is fabricated. Each perovskite solar cell 20 includes the first transparent electrode 21, the first transmission layer 22, the perovskite layer 23, the second transmission layer 24, the second transparent electrode 25, and the metal grid line 26 stacked on the transparent substrate 30 in sequence. The perovskite solar cell 20 further includes the side electrode 27 arranged on the first transparent electrode 21. Adjacent perovskite solar cells 20 are connected by conductive films stacked in the first grooves 41.

In the step S13, a plurality of crystalline silicon solar cells 10 are provided as the bottom cell 100 together in some embodiments. The structure of the crystalline silicon solar cell 10 is not limited herein.

In some embodiments, referring to FIG. 1, the crystalline silicon solar cell 10 may include a crystalline silicon substrate 13, and the crystalline silicon substrate 13 has a light receiving surface and a backlight surface. The light receiving surface of the crystalline silicon substrate 13 is a textured surface. The light receiving surface has a pn emitter junction. A first passivation layer 14 and a first anti-reflective layer 15 are sequentially stacked on the light receiving surface, the first metal electrode 11 is arranged on the light receiving surface of the crystalline silicon substrate 13 and is in contact connection with the pn emitter junction, and the first metal electrode 11 protrudes from the first passivation layer 14 and the first anti-reflective layer 15. A second passivation layer 16 and a second anti-reflective layer 17 are sequentially stacked on the backlight surface of the crystalline silicon substrate 13. A second metal electrode 12 is arranged on the backlight surface, and the second metal electrode 12 is in contact connection with the backlight surface and protrudes from the second passivation layer 16 and the second anti-reflective layer 17.

For the step S14 of stacking the top cell 200 and the bottom cell 100 together, the following implementation may be adopted:
referring to FIG. 2, FIG. 3, FIG. 4, and FIG. 5, the crystalline silicon solar cell 10 is inverted to enable the first metal electrode 11 of the crystalline silicon solar cell 10 to face the metal grid line 26 of the perovskite solar cell 20, and the crystalline silicon solar cell 10 is stacked above the perovskite solar cell 20 by aligning the first metal electrode 11 of the crystalline silicon solar cell 10 with the metal grid line 26 of the perovskite solar cell 20. The plurality of crystalline silicon solar cells 10 are stacked above the plurality of perovskite solar cells 20 along the first direction D1.

Further, in order to improve connection firmness of the crystalline silicon solar cell 10 and the perovskite solar cell 20, in some embodiments, after the tandem cell is formed, the top cell 200 and the bottom cell 100 may be mechanically crimped in a subsequent packaging process to securely connect the metal grid line 26 of the perovskite solar cell 20 to the first metal electrode 11 of the crystalline silicon solar cell 10. In the inventive embodiments, after the top cell 200 and the bottom cell 100 are stacked together, the tandem cell is subjected to heat treatment, so as to connect the metal grid line 26 of the perovskite solar cell 20 to the first metal electrode 11 of the crystalline silicon solar cell 10 by metal bonding. In some non-inventive embodiments, before the top cell 200 and the bottom cell 100 are stacked together, the metal grid line 26 of the perovskite solar cell 20 and/or the first metal electrode 11 of the crystalline silicon solar cell 10 may be coated with conductive silver paste, and then the top cell 200 and the bottom cell 100 are stacked together, such that the metal grid line 26 of the perovskite solar cell 20 and the first metal electrode 11 of the crystalline silicon solar cell 10 are connected by the conductive silver paste.

In some embodiments, the first metal electrode 11 of the crystalline silicon solar cell 10 is connected to the main grid 261 of the perovskite solar cell 20.

Each crystalline silicon solar cell 10 and one or more perovskite solar cells 20 are stacked together. It can be understood that a number of the perovskite solar cells 20 stacked above the crystalline silicon solar cell 10 can be flexibly adjusted according to a size of the crystalline silicon solar cell 10 and a size of the perovskite solar cell 20.

It is to be understood that the size of the perovskite solar cell 20 is typically smaller, and in order to match currents of the top cell 200 and the bottom cell 100, a plurality of perovskite solar cells 20 are typically stacked above one crystalline silicon solar cell 10. For example, 2, 3, 4, or more perovskite solar cells 20 are stacked above one crystalline silicon solar cell 10.

After the top cell 200 and the bottom cell 100 are stacked together, the second metal electrode 12 of the crystalline silicon solar cell 10 is connected to the side electrode 27 of the perovskite solar cell 20, so that the crystalline silicon solar cell 10 and the perovskite solar cell 20 are connected in series or in parallel.

For example, the second metal electrode 12 of the crystalline silicon solar cell 10 may be connected to the side electrode 27 of the perovskite solar cell 20 using a series welding process. By adjusting the connection mode, the crystalline silicon solar cells 10 can be connected in series or in parallel, the perovskite solar cells 20 can be connected in series or in parallel, and the crystalline silicon solar cells 10 and the perovskite solar cells 20 can be connected in series or in parallel, so as to connect the perovskite solar cells 20 of the top cell 200 and the crystalline silicon solar cells 10 of the bottom cell 100 to form the large-sized tandem cell which is suitable for photovoltaic conversion of the photovoltaic power generation device.

In some embodiments, referring to FIG. 2 and FIG. 4, a horizontal electrode 28 is formed on the transparent substrate 30 while the side electrode 27 is formed. The horizontal electrode 28 is provided on one sides of the plurality of perovskite solar cells 20 in a second direction D2 perpendicular to the first direction D1, and the plurality of side electrodes 27 are connected to the horizontal electrode 28.

Referring to FIG. 2 and FIG. 4, during the step S124 of forming the side electrode 27 on the top surface of each first transparent electrode 21 not covered by the first transmission layer 22, the deposited metal material also covers the edge clearing region 29 of the transparent substrate 30. The metal material is subjected to laser etching to form the side electrode 27 in the second groove 42, and meanwhile, the horizontal electrode 28 is formed in the edge clearing region 29 on one side of the transparent substrate 30 along the second direction D2. The horizontal electrode 28 extends along the first direction D1, the side electrodes 27 of the plurality of perovskite solar cells 20 are integrally formed with the horizontal electrodes 28, and one ends of the plurality of perovskite solar cells 20 are connected to the horizontal electrodes 28.

Referring to FIG. 2 and FIG. 4, after stacking the top cell 200 and the bottom cell 100 together, the manufacturing method further includes: connecting ends of the second metal electrodes 12 of the plurality of crystalline silicon solar cells 10 away from the horizontal electrode 28 along the second direction D2 to a busbar 50. The busbar 50 extends along the first direction D1 parallel to the horizontal electrode 28, so that the plurality of perovskite solar cells 20 of the top cell 200 are connected in parallel with each other, and the plurality of perovskite solar cells 20 of the top cell 200 and the plurality of crystalline silicon solar cells 10 of the bottom cell 100 are connected in parallel with each other.

In the second direction D2, an end of the second metal electrode 12 of the crystalline silicon solar cell 10 away from the horizontal electrode 28 is led out after being serially welded to the busbar 50. In this way, the metal grid lines 26 of the perovskite solar cells 20 of the top cell 200 are connected to the first metal electrodes 11 of the plural crystalline silicon solar cells 10 of the bottom cell 100, the side electrodes 27 of the plural perovskite solar cells 20 of the top cell 200 are connected to the horizontal electrodes 28, and the second metal electrodes 12 of the plural crystalline silicon solar cells 10 of the bottom cell 100 are connected to the busbar 50, so that the plural perovskite solar cells 20 of the top cell 200 are connected in parallel with each other, the plural crystalline silicon solar cells 10 of the bottom cell 100 are connected in parallel with each other, the plural perovskite solar cells 20 of the top cell 200 and the plural crystalline silicon solar cells 10 of the bottom cell 100 are connected in parallel with each other, a feasible design is provided for connecting the perovskite solar cells 20 of the top cell 200 and the crystalline silicon solar cells 10 of the bottom cell 100 to form the large-sized tandem cell, and therefore, the tandem cell is suitable for photovoltaic conversion of the photovoltaic power generation device.

In some embodiments, referring to FIG. 3 and FIG. 5, first horizontal electrodes 128 and second horizontal electrodes 228 are formed on the transparent substrate 30 while the side electrode 27 is formed. The first horizontal electrodes 128 are provided on one side of the perovskite solar cell 20 along the second direction D2, the first horizontal electrodes 128 are arranged at intervals along the first direction D1. The second horizontal electrodes 228 are provided on the other side of the perovskite solar cell 20 along the second direction D2, and the second horizontal electrodes 228 are arranged intervals along the first direction D1.

The plurality of perovskite solar cells 20 are connected into a plurality of groups through the first horizontal electrodes 128 and the second horizontal electrodes 228. The side electrodes 27 of the perovskite solar cells 20 in the same group are connected to the first horizontal electrodes or the second horizontal electrodes 228, and the plurality of groups of perovskite solar cells 20 arranged along the first direction D1 are alternately connected to the first horizontal electrodes 128 and the second horizontal electrodes 228.

During the step S124 of forming the side electrode 27 on the top surface of each first transparent electrode 21 not covered by the first transmission layer 22, referring to FIG. 3 and FIG. 5, the deposited metal material further covers the edge clearing region 29 of the transparent substrate 30. The metal material is subjected to laser etching to form the side electrode 27 in the second groove 42, and meanwhile, the first horizontal electrodes 128 arranged at intervals are formed in the edge clearing region 29 on one side, and the second horizontal electrodes 228 arranged at intervals are formed in the edge clearing region 29 on the other side along the second direction D2.

Referring to FIG. 3 and FIG. 5, each of the first horizontal electrodes 128 is connected to the side electrodes 27 of at least two perovskite solar cells 20 arranged in sequence in the first direction D1, so as to connect the at least two perovskite solar cells 20 into one group. Further, the first horizontal electrode 128 is integrally formed with the side electrodes 27 of the perovskite solar cells 20 of the same group.

Each of the second horizontal electrodes 228 is connected to the side electrodes 27 of at least two perovskite solar cells 20 arranged in sequence in the first direction D1, so as to connect the at least two perovskite solar cells 20 into one group. Further, the second horizontal electrode 228 is integrally formed with the side electrodes 27 of the perovskite solar cells 20 of the same group.

The plurality of groups of perovskite solar cells 20 arranged in the first direction D1 are connected into one group by the first horizontal electrodes 128 and the second horizontal electrodes 228 at intervals.

In some embodiments, each group of perovskite solar cells 20 includes two perovskite solar cells 20.

In some embodiments, referring to FIG. 3 and FIG. 5, the top cell 200 and the bottom cell 100 are stacked together, and each crystalline silicon solar cell 10 is stacked above one group of perovskite solar cells 20. The second metal electrode 12 of each crystalline silicon solar cell 10 is connected to the first horizontal electrodes 128 or the second horizontal electrodes 228 of the adjacent group of perovskite solar cells 20 along the first direction D1, so that the plurality of groups of perovskite solar cells 20 of the top cell 200 and the plurality of crystalline silicon solar cells 10 of the bottom cell 100 are connected in series.

Referring to FIG. 3 and FIG. 5, each of the crystalline silicon solar cells 10 is stacked above one group of perovskite solar cells 20, and the first metal electrode 11 of the crystalline silicon solar cell 10 is connected to the metal grid line 26 of the perovskite solar cell 20. Then, the second metal electrode 12 of the crystalline silicon solar cell 10 is serially welded to the first horizontal electrodes 128 or the second horizontal electrodes 228 of the adjacent group of perovskite solar cells 20 in the first direction D1, and finally led out through the busbar 50. In this way, the perovskite solar cells 20 of the same group are connected in parallel to increase the output current of the perovskite solar cells 20 stacked above the crystalline silicon solar cell 10 and allow the output current to be matched with the crystalline silicon solar cell 10, the plurality of groups of perovskite solar cells 20 arranged along the first direction D1 are sequentially connected in series, and the plurality of crystalline silicon solar cells 10 arranged along the first direction D1 are sequentially connected in series through the first horizontal electrodes 128 and the second horizontal electrodes 228 and then led out through the busbar 50.

In this way, the feasible design is provided for connecting the perovskite solar cell 20 of the top cell 200 to the crystalline silicon solar cell 10 of the bottom cell 100 to form the large-sized tandem cell, so that the tandem cell is suitable for photovoltaic conversion of the photovoltaic power generation device.

It can be understood that in some embodiments of the manufacturing method of a tandem cell, the crystalline silicon solar cell 10 of the bottom cell 100 is stacked above the perovskite solar cell 20 of the top cell 200 to connect the bottom cell 100 and the top cell 200 together, which is beneficial to reducing manufacturing difficulty and saving a production cost. When the tandem cell performs photoelectric conversion, the transparent substrate 30 of the top cell 200 should be arranged towards light, and the bottom cell 100 is arranged below the top cell 200 along an incident direction of the light.

According to some embodiments, a photovoltaic module is provided, including the tandem cell according to some embodiments, or including a tandem cell manufactured by the manufacturing method of a tandem cell according to some embodiments.

In the photovoltaic module according to some embodiments, a perovskite solar cell 20 of a top cell 200 is stacked above a crystalline silicon solar cell 10 of a bottom cell 100, a metal electrode 26 of the perovskite solar cell 20 is connected to a first metal electrode 11 of the crystalline silicon solar cell 10, an on-resistance of the connection between the metal grid line 26 and the first metal electrode 11 is small, and the top cell 200 and the bottom cell 100 have better conductivity, which facilitates a further improvement of a photoelectric conversion efficiency of the photovoltaic module.

## Claims

1. A tandem cell, comprising:
a bottom cell (100) comprising a plurality of crystalline silicon solar cells (10), and a light receiving surface of each crystalline silicon solar cell (10) being provided with a first metal electrode (11); and
a top cell (200) comprising a plurality of perovskite solar cells (20), the plurality of perovskite solar cells (20) being stacked above the light receiving surface of the crystalline silicon solar cell (10), a side of the perovskite solar cell (20) facing the light receiving surface of the crystalline silicon solar cell (10) being provided with a metal grid line (26), and the metal grid line (26) of the perovskite solar cell (20) being in connection with the first metal electrode (11) of the crystalline silicon solar cell (10) by metal bonding.

2. The tandem cell according to claim 1, wherein the plurality of crystalline silicon solar cells (10) of the bottom cell (100) are sequentially arranged along a first direction, and a backlight surface of the crystalline silicon solar cell (10) away from the perovskite solar cell (20) is provided with a second metal electrode (12);
the plurality of perovskite solar cells (20) of the top cell (200) are sequentially arranged along the first direction, a side of the top cell (200) away from the bottom cell (100) is provided with a transparent substrate (30), each perovskite solar cell (20) comprises a first transparent electrode (21), a first transmission layer (22), a perovskite layer (23), a second transmission layer (24), and a second transparent electrode (25) that are sequentially stacked from the transparent substrate (30) to the bottom cell (100), the metal grid line (26) is arranged on a side of the second transparent electrode (25) adjacent to the bottom cell (100), the perovskite solar cell (20) further comprises a side electrode (27) provided on a side of the first transparent electrode (21) facing the bottom cell (100);
the second metal electrode (12) of the crystalline silicon solar cell (10) is connected to the side electrode (27) of the perovskite solar cell (20), so that the crystalline silicon solar cell (10) and the perovskite solar cell (20) are connected in series or in parallel.

3. The tandem cell according to claim 2, wherein the plurality of perovskite solar cells (20) of the top cell (200) are connected in parallel with each other, and the plurality of perovskite solar cells (20) of the top cell (200) and the plurality of crystalline silicon solar cells (10) of the bottom cell (100) are connected in parallel with each other.

4. The tandem cell according to claim 2, wherein the plurality of perovskite solar cells (20) of the top cell (200) are connected into a plurality of groups connected in series, the perovskite solar cells (20) of one group are connected in parallel with each other, and the plurality of groups of perovskite solar cells (20) are connected to the plurality of crystalline silicon solar cells (10) of the bottom cell (100) in series.

5. The tandem cell according to claim 3 or 4, wherein the top cell (200) further comprises a horizontal electrode (28), the horizontal electrode (28) is provided on the transparent substrate (30) on one sides of the plurality of perovskite solar cells (20) along a second direction perpendicular to the first direction, and ends of the plurality of side electrodes (27) are connected to the horizontal electrode (28).

6. The tandem cell according to claim 5, wherein the bottom cell (100) further comprises a busbar (50), the busbar (50) is provided on a side of the horizontal electrode (28) along the second direction, the busbar (50) extends along the first direction, and ends of the second metal electrodes (12) of the plural crystalline silicon solar cells (10) away from the horizontal electrode (28) are connected to the busbar (50).

7. The tandem cell according to claim 3 or 4, wherein the top cell (200) comprises:
a plurality of first horizontal electrodes (128) provided on the transparent substrate (30) on one side of the perovskite solar cell (20) along the second direction, and the plurality of first horizontal electrodes (128) being arranged at intervals along the first direction; and
a plurality of second horizontal electrodes (228) provided on the transparent substrate (30) on the other side of the perovskite solar cell (20) along the second direction, and the plurality of second horizontal electrodes (228) being arranged at intervals along the first direction;
wherein the side electrodes (27) of the perovskite solar cells (20) in the same group are connected to the first horizontal electrode (128) or the second horizontal electrode (228), and the plurality of groups of perovskite solar cells (20) arranged along the first direction are alternately connected to the first horizontal electrode (128) and the second horizontal electrode (228);
wherein one group of perovskite solar cells (20) are stacked above each crystalline silicon solar cell (10), and along the first direction, the second metal electrode (12) of each crystalline silicon solar cell (10) is sequentially connected to the first horizontal electrodes (128) or the second horizontal electrodes (228) of the adjacent group of perovskite solar cells (20).

8. A photovoltaic module, comprising the tandem cell according to any one of claims 1 to 7.

9. A method of manufacturing a tandem cell, comprising:
providing a transparent substrate (30);
forming a top cell (200) on the transparent substrate (30), the top cell (200) comprising a plurality of perovskite solar cells (20), and a top surface of each perovskite solar cell (20) being provided with a metal grid line (26);
providing a bottom cell (100), the bottom cell (100) comprising a plurality of crystalline silicon solar cells (10), and a light receiving surface of each crystalline silicon solar cell (10) being provided with a first metal electrode (11); and
stacking the top cell (200) and the bottom cell (100) together, the top surface of the perovskite solar cell (20) facing the light receiving surface of the crystalline silicon solar cell (10), and the metal grid line (26) of the perovskite solar cell (20) being in connection with the first metal electrode (11) of the crystalline silicon solar cell (10) by metal bonding.

10. The method of manufacturing the tandem cell according to claim 9, wherein forming the top cell (200) on the transparent substrate (30), the top cell (200) comprising the plurality of perovskite solar cells (20) comprises:
forming a plurality of first transparent electrodes (21) arranged at intervals along a first direction on the transparent substrate (30);
forming a first transmission layer (22) on the first transparent electrode (21), the first transmission layer (22) covering part of a top surface of the first transparent electrode (21) and part of a top surface of the first transparent electrode (21) adjacent thereto;
forming a perovskite layer (23), a second transmission layer (24), and a second transparent electrode (25) that are sequentially stacked on the first transmission layer (22), and forming a metal grid line (26) on the second transparent electrode (25); and
forming a side electrode (27) on a top surface of each first transparent electrode (21) that is not covered by the first transmission layer (22), thus forming the plurality of perovskite solar cells (20);
wherein a backlight surface of the crystalline silicon solar cell (10) away from the perovskite solar cell (20) is provided with a second metal electrode (12), and after the top cell (200) and the bottom cell (100) are stacked together, the second metal electrode (12) of the crystalline silicon solar cell (10) is connected to the side electrode (27) of the perovskite solar cell (20), so that the crystalline silicon solar cell (10) and the perovskite solar cell (20) are connected in series or in parallel.

11. The method of manufacturing the tandem cell according to claim 10, wherein a horizontal electrode (28) is formed on the transparent substrate (30) while forming the side electrode (27), the horizontal electrode (28) is provided on one sides of the plurality of perovskite solar cells (20) along a second direction perpendicular to the first direction, and the plurality of side electrodes (27) are connected to the horizontal electrode (28).

12. The method of manufacturing the tandem cell according to claim 11, wherein after stacking the top cell (200) and the bottom cell (100) together, the method further comprises:
connecting ends of the second metal electrodes (12) of the plurality of crystalline silicon solar cells (10) away from the horizontal electrode (28) along the second direction to a busbar (50), the busbar (50) extending parallel to the horizontal electrode (28) along the first direction, so that the plurality of perovskite solar cells (20) of the top cell (200) are connected in parallel with each other, and the plurality of perovskite solar cells (20) of the top cell (200) and the plurality of crystalline silicon solar cells (10) of the bottom cell (100) are connected in parallel with each other.

13. The method of manufacturing the tandem cell according to claim 10, wherein a plurality of first horizontal electrodes (128) and a plurality of second horizontal electrodes (228) are formed on the transparent substrate (30) while forming the side electrode (27), the first horizontal electrodes (128) are provided on one side of the perovskite solar cell (20) along the second direction, the first horizontal electrodes (128) are arranged at intervals along the first direction, the second horizontal electrodes (228) are arranged on the other side of the perovskite solar cell (20) along the second direction, and the second horizontal electrodes (228) are arranged intervals along the first direction.

14. The method of manufacturing the tandem cell according to claim 10, wherein the plurality of perovskite solar cells (20) are connected into a plurality of groups through the first horizontal electrodes (128) and the second horizontal electrodes (228), the side electrodes (27) of the perovskite solar cells (20) in the same group are connected to the first horizontal electrodes (128) or the second horizontal electrodes (228), and the plurality of groups of perovskite solar cells (20) arranged along the first direction are alternately connected to the first horizontal electrodes (128) and the second horizontal electrodes (228).

15. The method of manufacturing the tandem cell according to claim 14, wherein the top cell (200) and the bottom cell (100) are stacked together, each crystalline silicon solar cell (10) is stacked above one group of perovskite solar cells (20), and the second metal electrode (12) of each crystalline silicon solar cell (10) is connected to the first horizontal electrodes (128) or the second horizontal electrodes (228) of the adjacent group of perovskite solar cells (20) along the first direction, so that the plurality of groups of perovskite solar cells (20) of the top cell (200) and the plurality of crystalline silicon solar cells (10) of the bottom cell (100) are connected in series.

## Patentansprüche

1. Tandemzelle, umfassend:
eine untere Zelle (100), umfassend eine Vielzahl von kristallinen Silizium-Solarzellen (10) und eine lichtempfangende Oberfläche jeder kristallinen Silizium-Solarzelle (10), die mit einer ersten Metallelektrode (11) bereitgestellt ist; und
eine obere Zelle (200), umfassend eine Vielzahl von Perowskit-Solarzellen (20), wobei die Vielzahl von Perowskit-Solarzellen (20) über der lichtempfangenden Oberfläche der kristallinen Silizium-Solarzelle (10) gestapelt ist, eine der lichtempfangenden Oberfläche der kristallinen Silizium-Solarzelle (10) zugewandte Seite der Perowskit-Solarzelle (20) mit einer Metallgitterleitung (26) bereitgestellt ist und die Metallgitterleitung (26) der Perowskit-Solarzelle (20) durch Metallbonding mit der ersten Metallelektrode (11) der kristallinen Silizium-Solarzelle (10) in Verbindung ist.

2. Tandemzelle nach Anspruch 1, wobei die Vielzahl von kristallinen Silizium-Solarzellen (10) der unteren Zelle (100) nacheinander entlang einer ersten Richtung angeordnet ist und eine von der Perowskit-Solarzelle (20) abgewandte Rücklichtoberfläche der kristallinen Silizium-Solarzelle (10) mit einer zweiten Metallelektrode (12) bereitgestellt ist;
wobei die Vielzahl von Perowskit-Solarzellen (20) der oberen Zelle (200) nacheinander entlang der ersten Richtung angeordnet ist, eine von der unteren Zelle (100) abgewandte Seite der oberen Zelle (200) mit einem transparenten Substrat (30) bereitgestellt ist, jede Perowskit-Solarzelle (20) eine erste transparente Elektrode (21), eine erste Übertragungsschicht (22), eine Perowskit-Schicht (23), eine zweite Übertragungsschicht (24) und eine zweite transparente Elektrode (25), die nacheinander von dem transparenten Substrat (30) zu der unteren Zelle (100) gestapelt sind, umfasst, die Metallgitterleitung (26) auf einer Seite der zweiten transparenten Elektrode (25), die der unteren Zelle (100) benachbart ist, angeordnet ist, die Perowskit-Solarzelle (20) ferner eine Seitenelektrode (27), die an einer der unteren Zelle (100) zugewandten Seite der ersten transparenten Elektrode (21) bereitgestellt ist, umfasst;
wobei die zweite Metallelektrode (12) der kristallinen Silizium-Solarzelle (10) mit der Seitenelektrode (27) der Perowskit-Solarzelle (20) verbunden ist, sodass die kristalline Silizium-Solarzelle (10) und die Perowskit-Solarzelle (20) in Reihe oder parallel geschaltet sind.

3. Tandemzelle nach Anspruch 2, wobei die Vielzahl von Perowskit-Solarzellen (20) der oberen Zelle (200) parallel zueinander geschaltet ist und die Vielzahl von Perowskit-Solarzellen (20) der oberen Zelle (200) und die Vielzahl von kristallinen Silizium-Solarzellen (10) der unteren Zelle (100) parallel zueinander geschaltet sind.

4. Tandemzelle nach Anspruch 2, wobei die Vielzahl von Perowskit-Solarzellen (20) der oberen Zelle (200) zu einer Vielzahl von in Reihe geschalteten Gruppen verbunden ist, die Perowskit-Solarzellen (20) einer Gruppe parallel zueinander geschaltet sind und die Vielzahl von Gruppen von Perowskit-Solarzellen (20) mit der Vielzahl von kristallinen Silizium-Solarzellen (10) der unteren Zelle (100) in Reihe geschaltet ist.

5. Tandemzelle nach Anspruch 3 oder 4, wobei die obere Zelle (200) ferner eine horizontale Elektrode (28) umfasst, die horizontale Elektrode (28) auf dem transparenten Substrat (30) auf einer Seite der Vielzahl von Perowskit-Solarzellen (20) entlang einer zweiten Richtung senkrecht zu der ersten Richtung bereitgestellt ist und Enden der Vielzahl von Seitenelektroden (27) mit der horizontalen Elektrode (28) verbunden ist.

6. Tandemzelle nach Anspruch 5, wobei die untere Zelle (100) ferner eine Sammelschiene (50) umfasst, die Sammelschiene (50) an einer Seite der horizontalen Elektrode (28) entlang der zweiten Richtung bereitgestellt ist, sich die Sammelschiene (50) entlang der ersten Richtung erstreckt und von der horizontalen Elektrode (28) abgewandte Enden der zweiten Metallelektroden (12) der Vielzahl von kristallinen Silizium-Solarzellen (10) mit der Sammelschiene (50) verbunden sind.

7. Tandemzelle nach Anspruch 3 oder 4, wobei die obere Zelle (200) Folgendes umfasst:
eine Vielzahl von ersten horizontalen Elektroden (128), die auf dem transparenten Substrat (30) auf einer Seite der Perowskit-Solarzelle (20) entlang der zweiten Richtung bereitgestellt ist, und wobei die Vielzahl von ersten horizontalen Elektroden (128) in Abständen entlang der ersten Richtung angeordnet ist; und
eine Vielzahl von zweiten horizontalen Elektroden (228), die auf dem transparenten Substrat (30) auf der anderen Seite der Perowskit-Solarzelle (20) entlang der zweiten Richtung angeordnet ist, und wobei die Vielzahl von zweiten horizontalen Elektroden (228) in Abständen entlang der ersten Richtung angeordnet ist;
wobei die Seitenelektroden (27) der Perowskit-Solarzellen (20) in derselben Gruppe mit der ersten horizontalen Elektrode (128) oder der zweiten horizontalen Elektrode (228) verbunden sind und die Vielzahl von Gruppen von Perowskit-Solarzellen (20), die entlang der ersten Richtung angeordnet ist, abwechselnd mit der ersten horizontalen Elektrode (128) und der zweiten horizontalen Elektrode (228) verbunden sind;
wobei eine Gruppe von Perowskit-Solarzellen (20) über jeder kristallinen Silizium-Solarzelle (10) gestapelt ist und entlang der ersten Richtung die zweite Metallelektrode (12) jeder kristallinen Silizium-Solarzelle (10) nacheinander mit den ersten horizontalen Elektroden (128) oder den zweiten horizontalen Elektroden (228) der benachbarten Gruppe von Perowskit-Solarzellen (20) verbunden ist.

8. Fotovoltaisches Modul, das die Tandemzelle nach einem der Ansprüche 1 bis 7 umfasst.

9. Verfahren zum Herstellen einer Tandemzelle, umfassend:
Bereitstellen eines transparenten Substrats (30);
Ausbilden einer oberen Zelle (200) auf dem transparenten Substrat (30), wobei die obere Zelle (200) eine Vielzahl von Perowskit-Solarzellen (20) umfasst und eine obere Oberfläche jeder Perowskit-Solarzelle (20) mit einer Metallgitterleitung (26) bereitgestellt ist;
Bereitstellen einer unteren Zelle (100), wobei die untere Zelle (100) eine Vielzahl von kristallinen Silizium-Solarzellen (10) umfasst, und eine lichtempfangende Oberfläche jeder kristallinen Silizium-Solarzelle (10) mit einer ersten Metallelektrode (11) bereitgestellt ist; und
Übereinanderstapeln der oberen Zelle (200) und der unteren Zelle (100), wobei die obere Oberfläche der Perowskit-Solarzelle (20) der lichtempfangenden Oberfläche der kristallinen Silizium-Solarzelle (10) zugewandt ist, und die Metallgitterleitung (26) der Perowskit-Solarzelle (20) durch Metallbonding mit der ersten Metallelektrode (11) der kristallinen Silizium-Solarzelle (10) in Verbindung ist.

10. Verfahren zum Herstellen der Tandemzelle nach Anspruch 9, wobei das Ausbilden der oberen Zelle (200) auf dem transparenten Substrat (30), wobei die obere Zelle (200) die Vielzahl von Perowskit-Solarzellen (20) umfasst, Folgendes umfasst:
Ausbilden einer Vielzahl von ersten transparenten Elektroden (21), die in Abständen entlang einer ersten Richtung auf dem transparenten Substrat (30) angeordnet ist;
Ausbilden einer ersten Übertragungsschicht (22) auf der ersten transparenten Elektrode (21), wobei die erste Übertragungsschicht (22) einen Teil einer oberen Oberfläche der ersten transparenten Elektrode (21) und einen daran benachbarten Teil einer oberen Oberfläche der ersten transparenten Elektrode (21) bedeckt;
Ausbilden einer Perowskit-Schicht (23), einer zweiten Übertragungsschicht (24) und einer zweiten transparenten Elektrode (25), die nacheinander auf der ersten Übertragungsschicht (22) gestapelt sind, und Ausbilden einer Metallgitterleitung (26) auf der zweiten transparenten Elektrode (25); und
Ausbilden einer Seitenelektrode (27) auf einer oberen Oberfläche jeder ersten transparenten Elektrode (21), die nicht von der ersten Übertragungsschicht (22) bedeckt ist, wodurch die Vielzahl von Perowskit-Solarzellen (20) ausgebildet wird;
wobei eine von der Perowskit-Solarzelle (20) abgewandte Rücklichtoberfläche der kristallinen Silizium-Solarzelle (10) mit einer zweiten Metallelektrode (12) bereitgestellt ist und nachdem die obere Zelle (200) und die untere Zelle (100) übereinandergestapelt sind, die zweite Metallelektrode (12) der kristallinen Silizium-Solarzelle (10) mit der Seitenelektrode (27) der Perowskit-Solarzelle (20) verbunden wird, sodass die kristalline Silizium-Solarzelle (10) und die Perowskit-Solarzelle (20) in Reihe oder parallel geschaltet sind.

11. Verfahren zum Herstellen der Tandemzelle nach Anspruch 10, wobei eine horizontale Elektrode (28) auf dem transparenten Substrat (30) ausgebildet wird, während die Seitenelektrode (27) ausgebildet wird, die horizontale Elektrode (28) an einer Seite der Vielzahl von Perowskit-Solarzellen (20) entlang einer zweiten Richtung senkrecht zu der ersten Richtung bereitgestellt ist und die Vielzahl von Seitenelektroden (27) mit der horizontalen Elektrode (28) verbunden ist.

12. Verfahren zum Herstellen der Tandemzelle nach Anspruch 11, wobei das Verfahren nach dem Übereinanderstapeln der oberen Zelle (200) und der unteren Zelle (100) ferner Folgendes umfasst:
Verbinden von Enden der zweiten Metallelektroden (12) der Vielzahl von kristallinen Silizium-Solarzellen (10) entlang der zweiten Richtung von der horizontalen Elektrode (28) weg zu einer Sammelschiene (50), wobei sich die Sammelschiene (50) parallel zu der horizontalen Elektrode (28) entlang der ersten Richtung erstreckt, sodass die Vielzahl von Perowskit-Solarzellen (20) der oberen Zelle (200) parallel zueinander geschaltet ist und die Vielzahl von Perowskit-Solarzellen (20) der oberen Zelle (200) und die Vielzahl von kristallinen Silizium-Solarzellen (10) der unteren Zelle (100) parallel zueinander geschaltet sind.

13. Verfahren zum Herstellen der Tandemzelle nach Anspruch 10, wobei eine Vielzahl von ersten horizontalen Elektroden (128) und eine Vielzahl von zweiten horizontalen Elektroden (228) auf dem transparenten Substrat (30) ausgebildet werden, während die Seitenelektrode (27) ausgebildet wird, die ersten horizontalen Elektroden (128) auf einer Seite der Perowskit-Solarzelle (20) entlang der zweiten Richtung bereitgestellt sind, die ersten horizontalen Elektroden (128) in Abständen entlang der ersten Richtung angeordnet sind, die zweiten horizontalen Elektroden (228) auf der anderen Seite der Perowskit-Solarzelle (20) entlang der zweiten Richtung angeordnet sind und die zweiten horizontalen Elektroden (228) in Abständen entlang der ersten Richtung angeordnet sind.

14. Verfahren zum Herstellen der Tandemzelle nach Anspruch 10, wobei die Vielzahl von Perowskit-Solarzellen (20) über die ersten horizontalen Elektroden (128) und die zweiten horizontalen Elektroden (228) zu einer Vielzahl von Gruppen verbunden ist, die Seitenelektroden (27) der Perowskit-Solarzellen (20) in derselben Gruppe mit den ersten horizontalen Elektroden (128) oder den zweiten horizontalen Elektroden (228) verbunden sind und die Vielzahl von entlang der ersten Richtung angeordneten Gruppen von Perowskit-Solarzellen (20) abwechselnd mit den ersten horizontalen Elektroden (128) und den zweiten horizontalen Elektroden (228) verbunden ist.

15. Verfahren zum Herstellen der Tandemzelle nach Anspruch 14, wobei die obere Zelle (200) und die untere Zelle (100) übereinandergestapelt sind, jede kristalline Silizium-Solarzelle (10) über einer Gruppe von Perowskit-Solarzellen (20) gestapelt ist, und die zweite Metallelektrode (12) jeder kristallinen Silizium-Solarzelle (10) entlang der ersten Richtung mit den ersten horizontalen Elektroden (128) oder den zweiten horizontalen Elektroden (228) der benachbarten Gruppe von Perowskit-Solarzellen (20) verbunden ist, sodass die Vielzahl von Gruppen von Perowskit-Solarzellen (20) der oberen Zelle (200) und die Vielzahl von kristallinen Silizium-Solarzellen (10) der unteren Zelle (100) in Reihe geschaltet sind.

## Revendications

1. Cellule tandem, comprenant :
une cellule inférieure (100) comprenant une pluralité de cellules solaires à silicium cristallin (10), et une surface réceptrice de lumière de chaque cellule solaire à silicium cristallin (10) étant pourvue d'une première électrode métallique (11) ; et
une cellule supérieure (200) comprenant une pluralité de cellules solaires à pérovskite (20), la pluralité de cellules solaires à pérovskite (20) étant empilées au-dessus de la surface réceptrice de lumière de la cellule solaire à silicium cristallin (10), un côté de la cellule solaire à pérovskite (20) faisant face à la surface réceptrice de lumière de la cellule solaire à silicium cristallin (10) étant pourvu d'une ligne de grille métallique (26), et la ligne de grille métallique (26) de la cellule solaire à pérovskite (20) étant reliée à la première électrode métallique (11) de la cellule solaire à silicium cristallin (10) par liaison métallique.

2. Cellule tandem selon la revendication 1, dans laquelle la pluralité de cellules solaires à silicium cristallin (10) de la cellule inférieure (100) sont agencées successivement le long d'une première direction, et une surface de rétroéclairage de la cellule solaire à silicium cristallin (10) éloignée de la cellule solaire à pérovskite (20) est pourvue d'une seconde électrode métallique (12) ;
la pluralité de cellules solaires à pérovskite (20) de la cellule supérieure (200) sont agencées successivement le long de la première direction, un côté de la cellule supérieure (200) éloigné de la cellule inférieure (100) est pourvu d'un substrat transparent (30), chaque cellule solaire à pérovskite (20) comprend une première électrode transparente (21), une première couche de transmission (22), une couche de pérovskite (23), une seconde couche de transmission (24) et une seconde électrode transparente (25) qui sont empilées successivement du substrat transparent (30) à la cellule inférieure (100), la ligne de grille métallique (26) est agencée sur un côté de la seconde électrode transparente (25) adjacent à la cellule inférieure (100), la cellule solaire à pérovskite (20) comprend en outre une électrode latérale (27) disposée sur un côté de la première électrode transparente (21) faisant face à la cellule inférieure (100) ;
la seconde électrode métallique (12) de la cellule solaire à silicium cristallin (10) est connectée à l'électrode latérale (27) de la cellule solaire à pérovskite (20), de sorte que la cellule solaire à silicium cristallin (10) et la cellule solaire à pérovskite (20) sont connectées en série ou en parallèle.

3. Cellule tandem selon la revendication 2, dans laquelle la pluralité de cellules solaires à pérovskite (20) de la cellule supérieure (200) sont connectées entre elles en parallèle, et la pluralité de cellules solaires à pérovskite (20) de la cellule supérieure (200) et la pluralité de cellules solaires à silicium cristallin (10) de la cellule inférieure (100) sont connectées entre elles en parallèle.

4. Cellule tandem selon la revendication 2, dans laquelle la pluralité de cellules solaires à pérovskite (20) de la cellule supérieure (200) sont connectées en une pluralité de groupes connectés en série, les cellules solaires à pérovskite (20) d'un groupe sont connectées entre elles en parallèle, et la pluralité de groupes de cellules solaires à pérovskite (20) sont connectés en série à la pluralité de cellules solaires à silicium cristallin (10) de la cellule inférieure (100).

5. Cellule tandem selon la revendication 3 ou 4, dans laquelle la cellule supérieure (200) comprend en outre une électrode horizontale (28), l'électrode horizontale (28) est disposée sur le substrat transparent (30) sur un côté de la pluralité de cellules solaires à pérovskite (20) le long d'une seconde direction perpendiculaire à la première direction, et les extrémités de la pluralité d'électrodes latérales (27) sont connectées à l'électrode horizontale (28).

6. Cellule tandem selon la revendication 5, dans laquelle la cellule inférieure (100) comprend en outre une barre omnibus (50), la barre omnibus (50) est disposée sur un côté de l'électrode horizontale (28) le long de la seconde direction, la barre omnibus (50) s'étend le long de la première direction, et les extrémités des secondes électrodes métalliques (12) de la pluralité de cellules solaires à silicium cristallin (10) éloignées de l'électrode horizontale (28) sont connectées à la barre omnibus (50).

7. Cellule tandem selon la revendication 3 ou 4, dans laquelle la cellule supérieure (200) comprend :
une pluralité de premières électrodes horizontales (128) disposées sur le substrat transparent (30) sur un côté de la cellule solaire à pérovskite (20) le long de la seconde direction, et la pluralité de premières électrodes horizontales (128) étant agencées à intervalles réguliers le long de la première direction ; et
une pluralité de secondes électrodes horizontales (228) disposées sur le substrat transparent (30) sur l'autre côté de la cellule solaire à pérovskite (20) le long de la seconde direction, et la pluralité de secondes électrodes horizontales (228) étant agencées à intervalles réguliers le long de la première direction ;
dans laquelle les électrodes latérales (27) des cellules solaires à pérovskite (20) du même groupe sont connectées à la première électrode horizontale (128) ou à la seconde électrode horizontale (228), et la pluralité de groupes de cellules solaires à pérovskite (20) agencées le long de la première direction sont connectées alternativement à la première électrode horizontale (128) et à la seconde électrode horizontale (228) ;
dans laquelle un groupe de cellules solaires à pérovskite (20) sont empilées au-dessus de chaque cellule solaire à silicium cristallin (10), et le long de la première direction, la seconde électrode métallique (12) de chaque cellule solaire à silicium cristallin (10) est connectée successivement aux premières électrodes horizontales (128) ou aux secondes électrodes horizontales (228) du groupe adjacent de cellules solaires à pérovskite (20).

8. Module photovoltaïque, comprenant la cellule tandem selon l'une quelconque des revendications 1 à 7.

9. Procédé de fabrication d'une cellule tandem, comprenant :
la fourniture d'un substrat transparent (30) ;
la formation d'une cellule supérieure (200) sur le substrat transparent (30), la cellule supérieure (200) comprenant une pluralité de cellules solaires à pérovskite (20), et une surface supérieure de chaque cellule solaire à pérovskite (20) étant poourvue d'une ligne de grille métallique (26) ;
la fourniture d'une cellule inférieure (100), la cellule inférieure (100) comprenant une pluralité de cellules solaires à silicium cristallin (10), et une surface réceptrice de lumière de chaque cellule solaire à silicium cristallin (10) étant pourvue d'une première électrode métallique (11) ; et
l'empilement de la cellule supérieure (200) et de la cellule inférieure (100) l'une sur l'autre, la surface supérieure de la cellule solaire à pérovskite (20) faisant face à la surface réceptrice de lumière de la cellule solaire à silicium cristallin (10), et la ligne de grille métallique (26) de la cellule solaire à pérovskite (20) étant en connexion avec la première électrode métallique (11) de la cellule solaire à silicium cristallin (10) par liaison métallique.

10. Procédé de fabrication de la cellule tandem selon la revendication 9, dans lequel la formation de la cellule supérieure (200) sur le substrat transparent (30), la cellule supérieure (200) comprenant la pluralité de cellules solaires à pérovskite (20), comprend :
la formation d'une pluralité de premières électrodes transparentes (21) agencées à intervalles réguliers le long d'une première direction sur le substrat transparent (30) ;
la formation d'une première couche de transmission (22) sur la première électrode transparente (21), la première couche de transmission (22) recouvrant une partie d'une surface supérieure de la première électrode transparente (21) et une partie d'une surface supérieure de la première électrode transparente (21) adjacente à celle-ci ;
la formation d'une couche de pérovskite (23), d'une seconde couche de transmission (24) et d'une seconde électrode transparente (25) qui sont empilées successivement sur la première couche de transmission (22), et la formation d'une ligne de grille métallique (26) sur la seconde électrode transparente (25) ; et
la formation d'une électrode latérale (27) sur une surface supérieure de chaque première électrode transparente (21) qui n'est pas recouverte par la première couche de transmission (22), formant ainsi la pluralité de cellules solaires à pérovskite (20) ;
dans lequel une surface de rétroéclairage de la cellule solaire à silicium cristallin (10) éloignée de la cellule solaire à pérovskite (20) est pourvue d'une seconde électrode métallique (12), et après l'empilement de la cellule supérieure (200) et de la cellule inférieure (100) l'une sur l'autre, la seconde électrode métallique (12) de la cellule solaire à silicium cristallin (10) est connectée à l'électrode latérale (27) de la cellule solaire à pérovskite (20), de sorte que la cellule solaire à silicium cristallin (10) et la cellule solaire à pérovskite (20) sont connectées en série ou en parallèle.

11. Procédé de fabrication de la cellule tandem selon la revendication 10, dans lequel une électrode horizontale (28) est formée sur le substrat transparent (30) tout en formant l'électrode latérale (27), l'électrode horizontale (28) est disposée sur un côté de la pluralité de cellules solaires à pérovskite (20) le long d'une seconde direction perpendiculaire à la première direction, et la pluralité d'électrodes latérales (27) sont connectées à l'électrode horizontale (28).

12. Procédé de fabrication de la cellule tandem selon la revendication 11, dans lequel, après l'empilement de la cellule supérieure (200) et de la cellule inférieure (100) l'une sur l'autre, le procédé comprend en outre :
la connexion des extrémités des secondes électrodes métalliques (12) de la pluralité de cellules solaires à silicium cristallin (10) éloignées de l'électrode horizontale (28) le long de la seconde direction à une barre omnibus (50), la barre omnibus (50) s'étendant parallèlement à l'électrode horizontale (28) le long de la première direction, de sorte que la pluralité de cellules solaires à pérovskite (20) de la cellule supérieure (200) sont connectées entre elles en parallèle, et que la pluralité de cellules solaires à pérovskite (20) de la cellule supérieure (200) et la pluralité de cellules solaires à silicium cristallin (10) de la cellule inférieure (100) sont connectées entre elles en parallèle.

13. Procédé de fabrication de la cellule tandem selon la revendication 10, dans lequel une pluralité de premières électrodes horizontales (128) et une pluralité de secondes électrodes horizontales (228) sont formées sur le substrat transparent (30) tout en formant l'électrode latérale (27), les premières électrodes horizontales (128) sont disposées sur un côté de la cellule solaire à pérovskite (20) le long de la seconde direction, les premières électrodes horizontales (128) sont agencées à intervalles réguliers le long de la première direction, les secondes électrodes horizontales (228) sont agencées sur l'autre côté de la cellule solaire à pérovskite (20) le long de la seconde direction, et les secondes électrodes horizontales (228) sont agencées à intervalles réguliers le long de la première direction.

14. Procédé de fabrication de la cellule tandem selon la revendication 10, dans lequel la pluralité de cellules solaires à pérovskite (20) sont connectées en une pluralité de groupes par l'intermédiaire des premières électrodes horizontales (128) et des secondes électrodes horizontales (228), les électrodes latérales (27) des cellules solaires à pérovskite (20) du même groupe sont connectées aux premières électrodes horizontales (128) ou aux secondes électrodes horizontales (228), et la pluralité de groupes de cellules solaires à pérovskite (20) agencées le long de la première direction sont connectés alternativement aux premières électrodes horizontales (128) et aux secondes électrodes horizontales (228).

15. Procédé de fabrication de la cellule tandem selon la revendication 14, dans lequel la cellule supérieure (200) et la cellule inférieure (100) sont empilées l'une sur l'autre, chaque cellule solaire à silicium cristallin (10) est empilée au-dessus d'un groupe de cellules solaires à pérovskite (20), et la seconde électrode métallique (12) de chaque cellule solaire à silicium cristallin (10) est connectée aux premières électrodes horizontales (128) ou aux secondes électrodes horizontales (228) du groupe adjacent de cellules solaires à pérovskite (20) le long de la première direction, de sorte que la pluralité de groupes de cellules solaires à pérovskite (20) de la cellule supérieure (200) et la pluralité de cellules solaires à silicium cristallin (10) de la cellule inférieure (100) sont connectées en série.
